# EUROPEAN PATENT SPECIFICATION

(11) **EP 2 695 297 B1**
(45) Date of publication and mention of the grant of the patent: **08.07.2015**
(21) Application number: 12722922.7
(22) Date of filing: 02.05.2012
(51) Int. Cl.: H03K 5/12, H04B 1/717, H04L 25/03, H01Q 9/28

(54) **ULTRA-WIDEBAND SHARPENER FOR EXCITATION A SYMMETRIC ANTENNA**
LTRABREITBANDIGER SCHÄRFER ZUR ERREGUNG EINER SYMMETRISCHEN ANTENNE
RAIDISSEUR DE FRONTS D'IMPULSIONS À BANDE ULTRA-LARGE POUR L'EXCITATION D'UNE ANTENNE SYMÉTRIQUE

(43) Date of publication of application: 12.02.2014
(73) Proprietor: Institute of Electronics and Computer Science, 1006 Riga (LV)
(72) Inventor: GREITANS, Modris, LV-1006 Riga (LV); KRUMINS, Karlis, LV-1006 Riga (LV); ARISTOVS, Vladimirs, LV-1006 Riga (LV)
(86) International application number: PCT/LV2012/000007
(87) International publication number: WO 2013/165229

(56) References cited:
- CN-A- 102 121 983
- US-A- 3 858 205
- US-A- 5 361 070
- US-A- 5 363 108
- US-A1- 2007 110 182
- ANFU ZHU; FU SHENG; ANXUE ZHANG: "An Implementation of Step Recovery Diode-Based UWB Pulse Generator", PROCEEDINGS OF 2010 IEEE INTERNATIONAL CONFERENCE ON ULTRA-WIDEBAND (ICUWB2010), 2010, - 2010, XP31784431, cited in the application
- AHMED ABBAS H AMERI ET AL: "Balanced pulse generator for UWB radar application", RADAR CONFERENCE (EURAD), 2011 EUROPEAN, IEEE, 12 October 2011 (2011-10-12), pages 198-201, XP032070532, ISBN: 978-1-4577-1156-5
- WEI REN ET AL: "High power variable nanosecond differential pulses generator design for GPR system", GROUND PENETRATING RADAR (GPR), 2010 13TH INTERNATIONAL CONFERENCE ON, IEEE, PISCATAWAY, NJ, USA, 21 June 2010 (2010-06-21), pages 1-5, XP031733957, ISBN: 978-1-4244-4604-9

## Description

### Technical field

This invention relates to Ultra-Wideband (UWB) sharpeners for providing excitation to a symmetric antenna.

### Background art

In publication of *"*Anfu Zhu, Fu Sheng, Anxue Zhang, An Implementation of Step Recovery Diode-Based UWB Pulse Generator. Proceedings of 2010 IEEE International Conference on Ultra-Wideband (ICUWB2010)" is described a design of Ultra-Wideband pulse generator comprising pulse shaper with a shapener. Said UWB sharpener for excitation a symmetric antenna comprises an avalanche transistor. A base of avalanche transistor is connected to an input of impulses. A collector and an emitter of the avalanche transistor both are connected to its timing resistor and forming capacitor. UWB pulse generator further comprises a step recovery diode which through its anode is connected to a first resistor, coupled to a positive pump source, and through its cathode is connected to the capacitor and to a second resistor, coupled to a negative pump source. A symmetric antenna consisting of two identical parts, wherein one part is connected to the anode of the step recovery diode via a capacitor and other part is connected to the cathode of the step recovery diode via a capacitor. When using antenna, given circuit does not allow matching optimally the output impendence of the generator to the input impendence of the antenna and independent adjustment of the amplitude of the output pulses.

Known pulse shaping circuit to power an antenna are described in US Patent No. 7812760, US Patent application No. US 2011/0013673 and US Patent application No. US 2003/0043078. Said circuits comprise an avalanche transistor as the input pulse sharpener and transformers as dividers for two paraphase pulses, containing paraphase amplifier output load, which as itself is a symmetric antenna. The disadvantages of such devices are the restrictions placed on the front of the output pulses, the presence of only one stage of exacerbation, the difficulty of matching the input impedance of a symmetric antenna.

The aim of the invention is to increase the efficiency of transmission for UWB symmetric antenna specifically by improving a control of amplitude of pulses and by providing an exact match between an output impedance of a sharpener and an input impedance of an antenna.

### Summary of the invention

Said aim is achieved by design of UWB sharpener for excitation a symmetric antenna, wherein sharpener's main elements are an avalanche transistor, a step recovery diode and a symmetric antenna. An avalanche transistor via its base is connected to an source of pulses, via its collector is connected to a timing resistor, which is coupled to a source of high voltage, and a forming or shaping capacitor, and via its emitter is connected to an emitter resistor, coupled to a ground, and a positive pulse control capacitor.

A step recovery diode via its anode is connected to a first resistor pumping current, which is coupled to a positive pump source, and via its cathode is connected to the positive pulse control capacitor and to a second resistor pumping current, which is coupled to a negative pump source.

A symmetric antenna consists of two identical parts, wherein a first part is connected to the anode of the step recovery diode and a second part is connected to the cathode of the step recovery diode.

The UWB sharpener further comprises a base resistor, a load resistor, a control capacitor and matching resistors.

A base resistor is connected to the base of the avalanche transistor and to the emitter of the avalanche transistor.

A load resistor and a negative pulse control capacitor are both connected to the forming or shaping capacitor, and other end of the negative pulse control capacitor is connected to the anode of the step recovery diode, and the other end of the load resistor is connected to a ground. Such a circuit provides improved control of amplitude of the pulses.

The sharpener further comprises a first matching resistor is connected to the anode of the step recovery diode and to the first part of the symmetric antenna, and a second matching resistor is connected to the cathode of the step recovery diode and the second part of the symmetric antenna. Said design provides an exact match between an output impedance of the sharpener and an input impedance of the antenna.

### Brief description of drawings

Fig. 1 illustrates a prior art of UWB sharpener for excitation a symmetric antenna.
Fig. 2 illustrates a UWB sharpener 1 for excitation a symmetric antenna constructed in accordance with the present invention.
Fig. 3 illustrates impulses describing a work of a UWB sharpener from the moment of receiving an activation impulse.
Fig. 4 illustrates radio pulses emitted by a symmetric antenna.

### Detailed description of the invention

Next, with reference to drawings, the present invention will be described in detail.

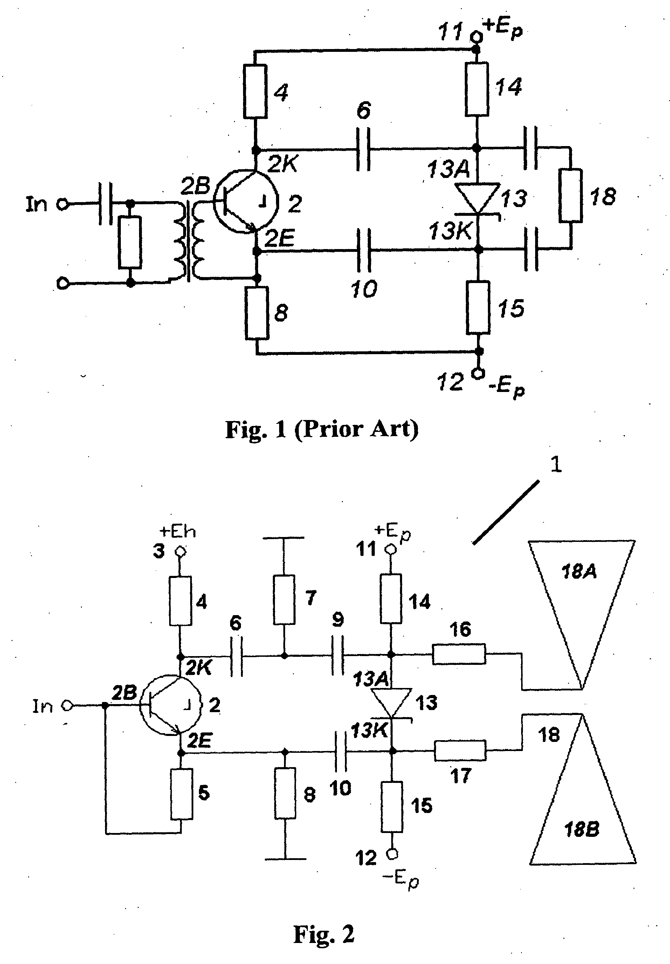

In Fig. 2 is shown Ultra-Wideband (UWB) sharpener **1** for excitation a symmetric antenna **18.** The UWB sharpener **1** comprises an avalanche transistor **2,** which via its base **2B** is connected to an source of pulses **In,** but via its collector **2K** is connected to a timing resistor **4,** coupled to a source of high voltage **3.** A forming capacitor **6** is also connected to the collector **2K** of the avalanche transistor **2.** The sharpener **1** also comprises an emitter resistor **8** and a positive pulse control capacitor **10** that are connected to an emitter **2E** of the avalanche transistor **2,** wherein the emitter resistor **8** is coupled to a ground. The circuit of the sharpener **1** also comprises a step recovery diode **13** (SRD), which via its anode **13A** is connected to a first pumping resistor **14,** coupled to a positive pump source **11,** and via its cathode **13K** is connected to the positive pulse control capacitor **10** and to a second pumping resistor **15,** wherein the second pumping resistor **15** is coupled to a negative pump source **12.** At the output of the sharpener **1** is provided a symmetric antenna **18** comprising two identical antenna parts **18A** and **18B.** The one part **18A** of the antenna **18** is connected to the anode **13A** of the step recovery diode **13** and other part **18B** is connected to the cathode **13K** of the step recovery diode **13.**

The UWB sharpener **1** further comprises a base resistor **5** connected to the base **2B** of the avalanche transistor **2** and to the emitter **2E** of the avalanche transistor **2.** Said design of circuit decreases a drift of forming pulse. The UWB sharpener **1** further comprises a load resistor **7** and a negative pulse control capacitor **9,** wherein the load resistor **7** and the negative pulse control capacitor **9** are connected to the forming capacitor **6.** Other end of the negative pulse control capacitor **9** is connected to the anode **13A** of the step recovery diode **13,** and the other end of the load resistor **7** is coupled to a ground. It was found out that such a design of circuit helps to adjust amplitude of pulses much more easily comparing to the state of art sharpeners.

Additionally, the UWB sharpener **1** comprises matching resistors **16** and **17,** wherein the first matching resistor **16** is connected between the anode **13A** of the step recovery diode **13** and the one part **18A** of the symmetric antenna **18.** The second matching resistor **17** is connected between the cathode **13K** of the step recovery diode **13** and the second part **18B** of the symmetric antenna **18.** In the state of art sharpeners as it is shown in Fig. 1 instead of the resistor **16** and **17** capacitors are used. Usage of resistors **16** and **17** and by adding previously made modifications of the circuit provides a possibility to maintain exact match of quantity between an output impedance of the sharpener **1** and an input impedance of the antenna **18.**

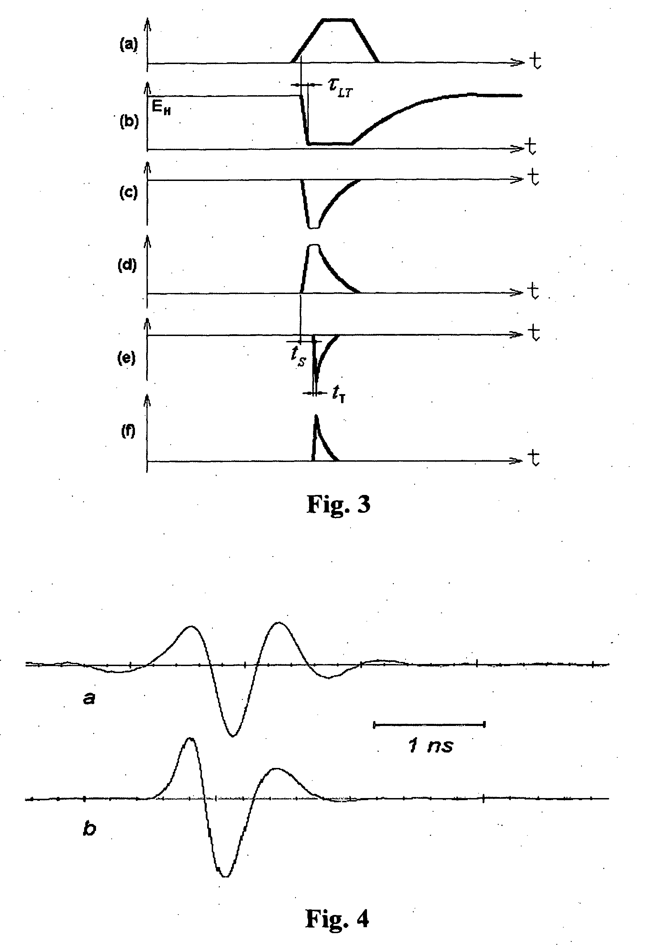

Fig. 3 illustrates (a) - an activation impulse at an input **In;** (b) - an impulse at the collector **2K** of the avalanche transistor **2;** (c) - a pulse at the load resistor **7;** (d) - a pulse at the emitter resistor **8;** (e) - a pulse at the anode **13A** of the step recovery diode **13;** and (f) - a pulse at the cathode **13A** of the step recovery diode **13.**

Fig. 4 (a) illustrates a shape of emitted radio pulse in the absence of agreement with an input impendence of a symmetric antenna. Given figure illustrates impulses when there are no matching resistors **16** and **17** connected. Fig. 4 (b) illustrates a shape of emitted radio pulse at the optimum agreement with an input impendence of a symmetric antenna.

It should be understood by those skilled in the art that the structure and details of the present invention may be changed in various manners without departing from the scope of the present invention.

### List of reference numerals

1 - a sharpener;
2 - an avalanche transistor;
2B - a base of the avalanche transistor;
2E - an emitter of the avalanche transistor;
2K - a collector of the avalanche transistor;
3 - a source of high voltage;
4 - a timing resistor;
5 - a base resistor;
6 - a forming capacitor;
7 - a load resistor;
8 - an emitter resistor;
9 - a negative pulse control capacitor;
10 - a positive pulse control capacitor;
11 - a positive pump source;
12 - a negative pump source;
13 - a step recovery diode;
13A - an anode of the step recovery diode;
13K - a cathode of the step recovery diode;
14 - a first pumping resistor;
15 - a second pumping resistor;
16 - a first matching resistor;
17 - a second matching resistor;
18 - symmetric antenna;
18A - one part of a symmetric antenna;
18B - other part of a symmetric antenna;
In - a source of pulses.

## Claims

1. An Ultra-Wideband sharpener for excitation a symmetric antenna, wherein sharpener (1) comprises:
- an avalanche transistor (2) which through its base (2B) is connected to an source of pulses (In), through its collector (2K) is connected to a timing resistor (4), coupled to a source of high voltage (3), and a forming capacitor (6), and through its emitter (2E) is connected to an emitter resistor (8), coupled to a ground, and a positive pulse control capacitor (10),
- a step recovery diode (13) which via its anode (13A) is connected to a first pumping resistor (14), coupled to a positive pump source (11), and through its cathode (13K) is connected to the positive pulse control capacitor (10) and to a second pumping resistor (15), coupled to a negative pump source (12),
- a symmetric antenna (18) comprises two identical parts (18A; 18B), wherein one part (18A) is connected to the anode (13A) of the step recovery diode (13) and other part (18B) is connected to the cathode (13K) of the step recovery diode (13),
**characterized in that**
UWB sharpener (1) further comprises:
- a base resistor (5) where it is connected to the base (2B) of the avalanche transistor (2) and to the emitter (2E) of the avalanche transistor (2),
- a load resistor (7) and a negative pulse control capacitor (9) where the load resistor (7) and the negative pulse control capacitor (9) are connected to the forming capacitor (6), and other end of the negative pulse control capacitor (9) is connected to the anode (13A) of the step recovery diode (13), and the other end of the load resistor (7) is connected to a ground,
- matching resistors (16, 17), wherein the first matching resistor (16) is connected between the anode (13A) of the step recovery diode (13) and the one part (18A) of the symmetric antenna (18), and the second matching resistor (17) is connected between the cathode (13K) of the step recovery diode (13) and the second part (18B) of the symmetric antenna (18).

## Patentansprüche

1. Der Ultrabreitband-Sendeempfänger zur Anregung einer symmetrische Antenne - wobei der Sendeempfänger (1) folgende Teile enthält:
- einen Avalanchetransistor (2), der über seine Basis (2B) an einer Impulsquelle (In) angeschlossen und über einen Sammler (2K) mit einem Zeitgeber-Widerstand (4) verbunden ist, der mit einer Hochspannungsquelle (3) und mit einem formgebenden Kondensator (6) verbunden ist, und über den Emitter (2E) mit dem Emitterwiderstand (8) verbunden ist, der mit der Masse und einem Steuerkondensator für positive Impulse (10) verbunden ist,
- eine Speicherschaltdiode (13), die über ihre Anode (13A) mit dem ersten Pumpenwiderstand (14) verbunden ist, der an eine positive Pumpquelle (11) angeschlossen ist, und über ihre Kathode (13K) mit dem positiven Impulssteuerkondensator (10) und mit dem zweiten Pumpenwiderstand (15) verbunden ist, der an eine negativen Pumpquelle (12) angeschlossen ist.
- eine symmetrische Antenne (18), die zwei identische Teile hat (18A; 18B), wobei der eine Teil (18A) mit der Anode (13A) der Speicherschaltdiode (13) und der andere Teil (18B) ist mit der Kathode (13K) der Speicherschaltdiode - (13) verbunden ist,
**ist dadurch gekennzeichnet, dass**
der UWB-Sendeempfänger (1) ferner enthält:
- einen Basiswiderstand (5), der mit der Basis (2B) des Avalanchetransistors (2) und mit dem Emitter (2E) des Avalanchetransistors (2) verbunden ist,
- einen Lastwiderstand (7) und einen Steuerkondensator für negative Impulse (9), wobei beide mit dem formgebenden Kondensator (6) verbunden sind und am andere Ende des negativen Imulssteuerkondensators (9) - mit der Anode (13A) des Speicherschaltdiode (13) verbunden sind, und das andere Ende des Lastwiderstands (7) ist mit der Masse verbunden,
- passende Widerstände (16, 17), wobei der erste (16) mit der Anode (13A) der Speicherschaltdiode (13) und mit dem ersten Teil (18A) der symmetrischen Antenne (18) verbunden ist, und der zweite passende Widerstand (17) mit der Kathode (13K) der Speicherschaltdiode (13) und dem zweiten Teil (18B) der symmetrischen Antenne (18) verbunden ist.

## Revendications

1. Aiguiseur à bande ultra large pour l'excitation de l'antenne symétrique, où l'aiguiseur (1) comprend:
- un transistor à avalanche (2) qui, par sa hase (2B) est relié à une source d'impulsions (In), par son collecteur (2K) est relié à une résistance de synchronisation (4), couplé à une source de haute tension (3), et un condensateur de formage (6), et par son émetteur (2E) est reliée à une résistance d'émetteur (8), couplée à une masse, et un condensateur de commande d'impulsion positive (10),
- une diode de récupération de l'étape (13) qui par son anode (13A) est reliée à une première résistance de pompage (14), couplée à une source de pompage positive(11), et par sa cathode (13K) est connectée au condensateur de commande d'impulsion positive (10) et à une deuxième résistance de pompage (15), couplée à une source de pompage négative(12),
- une antenne asymétrique (18) comprend deux parties identiques (18A; 18B), dans laquelle une partie (18A) est reliée à l'anode (13A) de la diode de récupération de l'étape (13) et l'autre partie (18B) est reliée à la cathode (13K) de la diode de récupération de l'étape (13),
**caractérisé en ce que**
Aiguiseur à bande ultra large (1) comprend en outre:
- une résistance de base (5) où il est relié à la base (2B) du transistor à avalanche (2) et à l'émetteur (2E) du transistor à avalanche (2),
- une résistance de charge (7) et un condensateur de commande d'impulsion négative (9) où la résistance de charge (7) et le condensateur de commande d'impulsion négative (9) sont reliés au condensateur de formage (6), et l'autre extrémité du condensateur de commande d'impulsion negative(9) est reliée à l'anode (13A) de la diode de récupération de l'étape (13), et l'autre extrémité de la résistance de charge (7) est reliée à une masse,
- les résistances d'adaptation (16, 17), où la première résistance d'adaptation (16) est connectée entre l'anode (13A) de la diode de récupération de l'étape (13) et une partie (18A) de l'antenne asymétrique (18), et la seconde résistance d'adaptation (17) est connectée entre 1a cathode (13K) de la diode de récupération de l'étape (13) et l'autre partie (18B) de l'antenne symétrique (18).
